# EUROPEAN PATENT APPLICATION

(11) **EP 4 534 770 A1**
(43) Date of publication of application: **09.04.2025**
(21) Application number: 23814574.2
(22) Date of filing: 02.06.2023
(51) Int. Cl.: E04B 1/343, H05K 5/00, H05K 7/00

(54) **DATA PROCESSING CENTRE MODULE FORMED BY PREFABRICATED AND TRANSPORTABLE SEGMENTS, METHOD FOR BUILDING A DATA PROCESSING CENTRE MODULE, DATA PROCESSING CENTRE FORMED BY SAID MODULE AND METHOD FOR BUILDING SAID DATA PROCESSING CENTRE**

(30) Priority: 03.06.2022 BR 102022010903
(71) Applicant: MODULAR DATA CENTERS INDÚSTRIA COMÉRCIO E SERVIÇOS S.A., 06711-250 Cotia, SP (BR)
(72) Inventor: PEIGO, Marcos Vinicius Bernardes, 06455-020 Barueri (BR); ROSA, Franciele Nogueira Ferreira, 12955-000 Bom Jesus dos Perdões (BR); CRUZ, Eugênio Couto, 03111-001 São Paulo (BR)
(74) Representative: Pereira Garcia, João Luís
(86) International application number: PCT/BR2023/050181
(87) International publication number: WO 2023/230691

(57) **Abstract**

The present invention relates to a data processing center module (100) (1) consisting of prefabricated and transportable segments (101, 102), the module (100) being formed by the union of two substantially symmetrical halves (1001, 1002), each half (1001, 1002) also being formed by the union of one or more of its respective prefabricated and transportable segments (101, 102). The invention also relates to a method of construction of said module (100), where the segments (101, 102) are manufactured separately and transported individually as a standard load to the assembly site of the data processing center (1). The end of one segment (101) is joined to the other end of the adjacent segment (101') forming the first half (1001); the same process occurring for the union of the segments (101', 102') of the second half (1002). After the formation of the halves (1001, 1002), they are joined to form the module (100). The data processing center (1) is formed by the side-by-side arrangement of the modules (100). The invention also deals with the method of constructing the data processing center (1) that occurs by means of the assembly of a casing (30), by the insertion of the segments (101, 102) in said envelope (30) and by the side-by-side arrangement of said modules.

## Description

### FIELD OF THE INVENTION

The present invention belongs to the field of modular data processing centers that house computing systems (IT equipment) of one or more organizations.

In particular, the present invention deals with modular and scalable data processing centers while meeting the efficiency specifications and guarantees of a conventional (non-modular) data processing center.

Thus, the present invention presents a scalable, replicable, and customizable data processing center based on modules assembled on site. However, after the data processing center is assembled, the user experience is similar to that of a conventional masonry data processing center.

Even more specifically, the present invention relates to a module provided with prefabricated and transportable segments that are assembled at the site of the data processing center, with the segments comprising a metal structure, which are joined at the assembly site to form a module.

The aforementioned modules form a data processing center that is also housed by a casing. The envelope comprises a roof, which may have a raised floor, side portions delimiting the area of the data processing center, and the façade and facilities areas are made of masonry or other materials commonly used in conventional data processing centers.

### BACKGROUND OF THE ART

Nowadays, in the time of the knowledge society, data processing centers are structures of the utmost importance as they are where all of an organization's information is stored and protected. Thus, the function of a data processing center is to house servers, telecommunications equipment, and operational support areas.

Due to the growing market demand for this type of infrastructure, there is an increasing need for the rapid and flexible construction of data processing centers practically all over the planet.

In order to facilitate construction, we find state-of-the-art modular data processing centers with prefabricated structures which already include IT rack cabinets, cooling, uninterruptible power supplies (UPS), power distribution units, cables and connections, monitoring, lighting, door access control, among others.

However, state-of-the-art modular data processing centers have presented some technical problems, such as low flexibility because they are designed for a finite and static capacity. In other words, it is difficult to expand the capacity of state-of-the-art modular data processing centers, and it is equally complex to adapt flexibly to changes in market demands.

In short, modular data processing centers are already known in the state of the art. However, they have some difficulties and drawbacks, such as restrictions on rack capacity, energy potential and cooling equipment in the same area as the client's equipment. These limitations make it impossible to replicate them to meet large demands for data processing centers and varied technical specifications.

Currently, in the state of the art, modular, prefabricated data processing centers are found, with cooling and power systems attached to the rack areas. However, they do not guarantee integration, nor do they have the capacity for expansion and redundancy to mimic a conventional data processing center with all its capacity advantages.

An example of a limitation of a conventional data processing center: a data processing center with 200 racks of space that starts its operation with only 10 racks is not efficient, as it mobilizes capital for an infrastructure that is not being used (the capital invested at the beginning of its operation is not returned).

Furthermore, when an incident occurs in a large conventional data center, it can impact all the racks in the same room.

Another problem with conventional data processing centers is the average facility construction time, which varies from 18 to 24 months, when there are no unforeseen events.

As some equipment (or parts thereof) making up the infrastructure are imported, variables such as installation planning for non-standard spaces, negotiation time with foreign suppliers, complexity and slowness with licensing processes with public agencies, risks with transport logistics, slowness with customs clearance are some of the obstacles that invariably lead to delays in the completion of conventional data processing centers.

The present invention provides technical advantages that conventional large-scale data processing centers do not have - flexibility of expansion, optimized initial implementation cost and cost proportional to the growth of the data processing center, area of facilities to support the client's operation. In other words, the present invention manages to combine the advantages of modular data processing centers with the advantages of conventional large-scale data processing centers, while also mitigating the disadvantages of a conventional data processing center.

Nowadays, we no longer only process simple data such as numbers and text as in the past, but all types of data such as audio, images, videos from a big data perspective, and this generates an exponential demand for data processing.

These technological advances have led to a growing need for improvements in the infrastructure of modular data centers. As a result of the high power and high density required today, modular data processing centers have used simple, predefined downflow, room cool or cold containment aisle systems, which makes it a challenge to keep up with the exponential demand for increasingly high power.

Another disadvantage of state-of-the-art data processing centers is their high cost, especially in the initial stages of construction.

Furthermore, there are customers with non-optimized infrastructure with low consumption density per rack, which disadvantageously results in underutilization of the dimensioned environment, leading to lower efficiency of data processing centers (which leads to higher energy consumption).

Conventional data processing centers, on the other hand, are designed to operate under optimal conditions (close to full capacity). These optimal conditions of conventional data processing centers may not be achieved at the beginning of the operation. This is the major disadvantage of conventional data processing centers, the initial cost of implementation. Given the proportion, the conventional data processing center needs to have the rack area fully active, since the initial partial use results in higher costs proportional to the dimension.

On the other hand, state-of-the-art modular data processing centers cannot have large rack capacities, have restrictions on energy potential, redundancy, cooling equipment, among other limitations.

Patent document US20200146186 shows a modular data processing center that is capable of being transported on a highway, with the **IT** racks, electrical distribution system, uninterruptible power supply (UPS) batteries, and heating/ventilation/air conditioning (HVAC) already pre-installed. Thus, a manufacturer can ship a modular data processing center on the road as an integrated unit. The modular data processing center includes a prefabricated telecommunications data center or other modularly designed data centers.

However, the USA document itself discloses the limitations of these data processing centers: the only limit is the limit on the shipping of the cargo. In other words, the size of the modules is limited by the transportation rules established in the jurisdiction where the data processing center will be transported.

Advantageously, the prefabricated modules of the present invention are capable of being transported in any jurisdiction, to then form large-scale modular data processing centers and, furthermore, with all the advantages of a conventional large-scale data processing center, such as: redundancy and integration.

Furthermore, they can be found in the air containment system described in document US20200146186, which includes one or more HVAC units attached to the concrete side walls of the modular data processing center and air plenums attached to the concrete side walls.

The present invention advantageously has a casing that prevents direct incidence of sunlight, which increases the efficiency of the refrigeration system, in addition to providing a greater volume of air by joining two halves to form the module of the present invention.

Patent document EP2648496 also refers to high-density data center modules with an efficient cooling system. This cooling system allows the use of a hot aisle and a cold aisle through which air circulates to cool the server racks.

Document EP2648496 also discloses an aggregation aisle between the modules, but it is not capable of integrating the electrical system areas of each module. The aisle in this document is intended to circulate air, and not to integrate a data processing center.

In view of these challenges of the state of the art, that is, reducing the construction time of conventional data processing centers, reducing the risks of delays and widespread compromise of racks that make up large rooms of conventional (traditional) data processing centers, the present invention is now disclosed.

### OBJECTIVES OF THE INVENTION

The present invention has as main objectives:
- reduction of the average construction time compared to conventional data processing centers by up to 8 months;
- better energy efficiency than state-of-the-art modular data processing centers;
- risk reduction with the shutdown of hundreds of racks sharing the same cooling system in relation to conventional and modular state-of-the-art data processing centers;
- improved logistics compared to state-of-the-art modular data processing centers since segments can be transported without the need for special transportation requirements, as occurs with non-standard loads (which exceed regulatory dimensions);
- redundancy for refrigeration and electrical equipment per module and the ability to share resources between modules, optimizing redundancy as a whole in relation to state-of-the-art modular data processing centers;
- circulation aisle that facilitates the movement of customers and users as an improvement to the current offer of modular data processing centers;
- maintenance of equipment with no need to access the rack area compared to current conventional and modular data processing center offerings. The same improvement restricts customer and visitor access to vital operational equipment.

The present invention manages to combine the advantages of a conventional data processing center and modular data processing centers.

Thus, the present invention is advantageously scalable, with high capacity to support data processing equipment, the prefabricated modules allow for reduced assembly time, favorable logistics, greater technical flexibility, reduction of initial investments and risks presented by state-of-the-art data processing centers.

### SUMMARY OF THE INVENTION

The module of the present invention has a substantially parallelepipedal shape equipped at one of its ends with a dedicated and segregated room in substantially parallelepipedal shape to house a power supply system and at its opposite end a dedicated and segregated room in substantially parallelepipedal shape to house a refrigeration system.

The module of the present invention is constituted by the union of two substantially symmetrical halves in relation to a longitudinal plane perpendicular to a floor, each half being further constituted by the union of one or more of its respective prefabricated and transportable segments.

Between the power supply system room and the refrigeration system room, the module of the present invention is equipped with a main aggregation aisle and a dedicated and segregated room in substantially parallelepiped shape to house a rack area.

An access door to the racks, equipped with an access control, allows the movement of authorized users between the main aggregation aisle and the rack area. An access door to the power supply system room, also equipped with an access control, allows the movement of authorized users between the main aggregation aisle and the power supply system room.

Access to the main aggregation aisle is controlled and performed through a facilities area.

The union between the first half and the second half forms a containment aisle for hot or cold air common to both halves.

The halves are autonomous, so there is optimization of refrigeration equipment redundancy when combined.

Each half can share standby refrigeration equipment with each other.

Each of the halves is autonomous, consequently there is also optimization of the redundancy of equipment in the electrical power supply systems.

The present invention also discloses a method of constructing a module comprising the following steps:
- segments are manufactured outside the module deployment site;
- each of the segments is transported individually as standard cargo to the module assembly site;
- at the module assembly site, the end of one segment is joined to the other end of the adjacent segment, forming the first half;
- at the module assembly site, the end of one segment is joined to the other end of the adjacent segment, forming the second half, with the halves being substantially symmetrical;
- after forming each of the halves, the first half is joined to the second half, forming the module.

The construction method of a module further comprises one or more modules arranged side by side and interconnected from the larger side faces of adjacent modules, with the main aggregation aisle aligned between the modules.

The first module of the data processing center is located next to the facilities area, and user access control to one or more modules is performed through said facilities area.

The present invention also discloses a data processing center provided with a casing limited at the bottom by a floor raised in relation to the ground level where the data processing center will be mounted; limited at the top by a roof, which houses the data processing center in whole or in part; limited laterally and at the bottom respectively by closures, whereby at least one of said closures is performed by means of gates compatible, at least, with the dimensions of the segments; limited at the front by the area of facilities that is integrated into the casing in order to constitute the same set of data processing center.

The present invention further discloses a method of constructing the data processing center comprising the steps in any order:
a) construction of the casing, constructed from the execution of the sub-steps performed in any order:
   - construction of a solid foundation or raised floor above the ground where the data processing center will be built;
   - construction of the facilities area;
   - construction of the roof structure;
   - installation of roofing or use of existing roofing;
   - side closures;
   - bottom closure;
b) insertion of the segments inside the casing, which are assembled from the sub-steps executed in any order:
   - the segments are joined to form a first half;
   - segments substantially symmetrical to the segments are joined to form a second half substantially symmetrical to the first half;
   - after the formation of each of the halves, the first half is joined to the second half, forming the module;
c) the modules are arranged side by side inside the enclosure to form the modular data processing center.

### BRIEF DESCRIPTION OF THE FIGURES

Figure 1 shows a perspective view of a data processing center module that is the basis of the present invention.
Figure 2 shows an exploded perspective view showing the two halves of the module of the present invention.
Figure 3 shows a top view of a module of the present invention.
Figure 4 shows an exploded perspective view of a module of the present invention, with details of the segments.

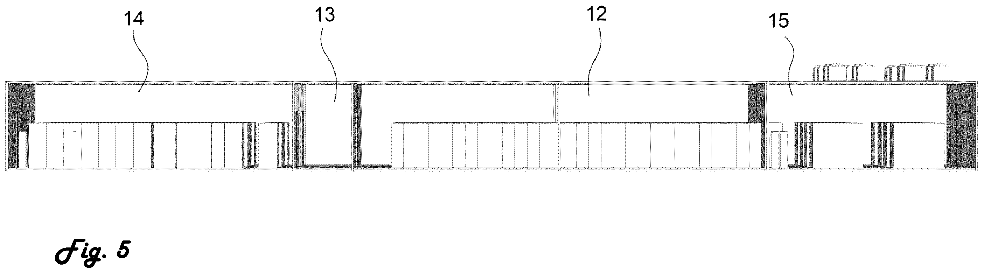

Figure 5 shows a side view of a module of the present invention.

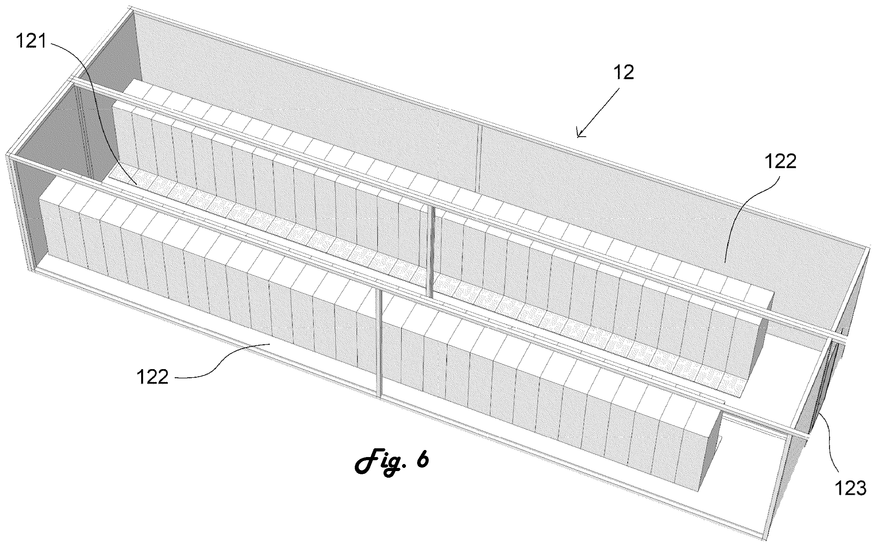

Figure 6 shows the detail of the rack area with an exemplary configuration of the hot-cold aisle arrangement.
Figure 7 shows details of the electrical power supply system.
Figure 8 shows details of the cooling system, highlighting the redundancy optimization.

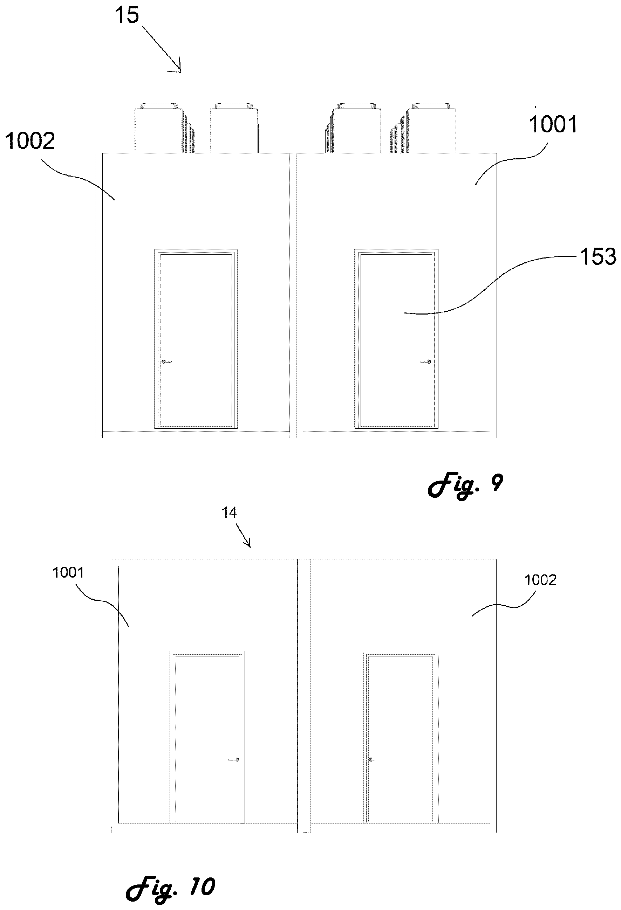

Figure 9 shows a side view of the module of the present invention, with details of the refrigeration system.
Figure 10 shows a side view of the module of the present invention, with details of the electrical power supply system.

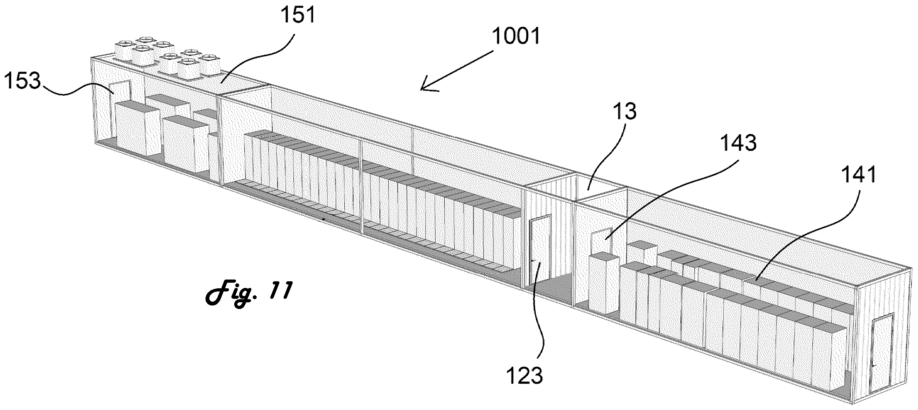

Figure 11 shows one half of the module of the present invention.
Figure 12 shows a longitudinal sectional view of a data processing center of the present invention, in which it is possible to view the auxiliary areas and facade of the data processing center on the right side and, above, the covering of the casing.
Figure 13 shows the front view of the facade of the modular data processing center in an embodiment of the invention. The facade emulates a conventional data processing center.
Figure 14 shows the floor plan of an embodiment of the data processing center of the present invention.
Figure 15 shows the floor plan of another embodiment of the data processing center of the present invention.

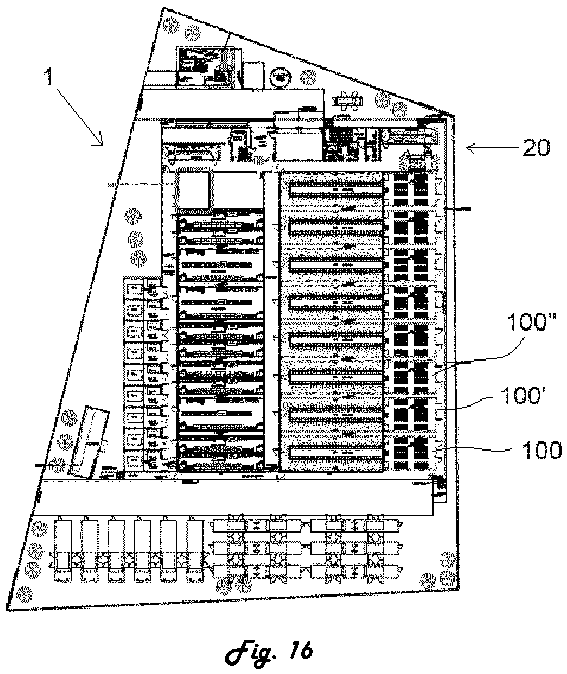

Likewise, Figure 16 shows the floor plan of another embodiment of the data processing center of the present invention.

### DETAILED DESCRIPTION OF THE INVENTION

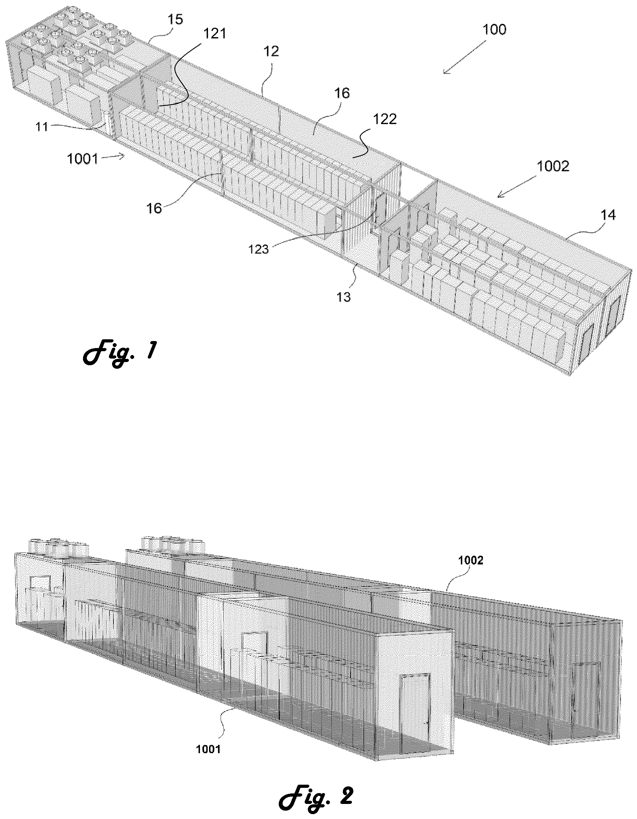

Figure 1 shows a module (100) of the data processing center that is the basis of the present invention. The module (100) is constituted by the union of a first half (1001) with the second half (1002), which are substantially symmetrical.

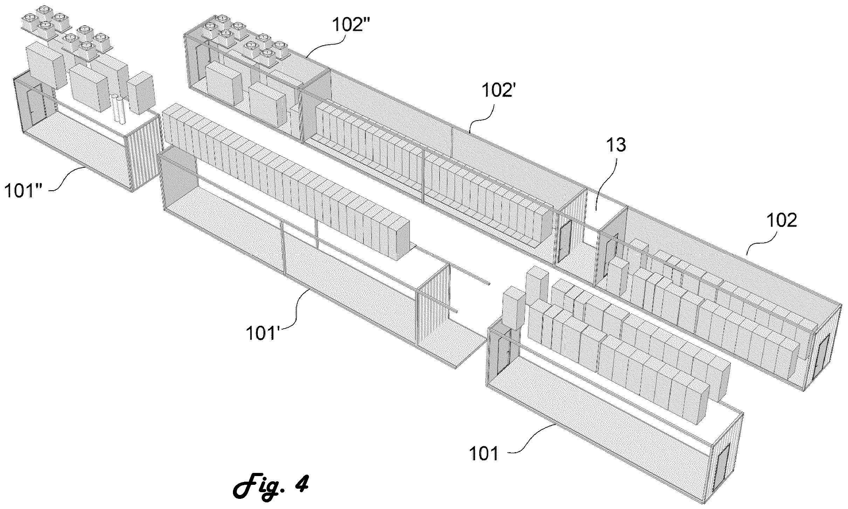

As shown in Figure 4, each of the halves (1001, 1002) is formed by the union of one or more prefabricated and transportable segments (101, 102). The segments (101, 102) are prefabricated in dimensions according to the jurisdiction through which the segments will be transported.

The segments (101, 101', 101") are joined to form the first half (1001) of the module (100). Similarly, the segments (102, 102', 102") are joined to form the second half (1002) of the module (100).

The construction of these segments (101, 102) is performed in a suitable location, such as a factory. A dedicated manufacturing site translates into greater efficiency in their construction. It is much more advantageous than assembly at the data processing center installation site itself and actions can be performed in parallel with the preparations of the assembly site, optimizing the total construction time.

As stated, the module (100) is constituted by the union of the first half (1001) with the second half (1002) providing a common and unique space for the rack area (12), similar to a conventional data processing center. This arrangement allows the use of a hot (121) and cold (122) containment aisle, as shown in Figure 1.

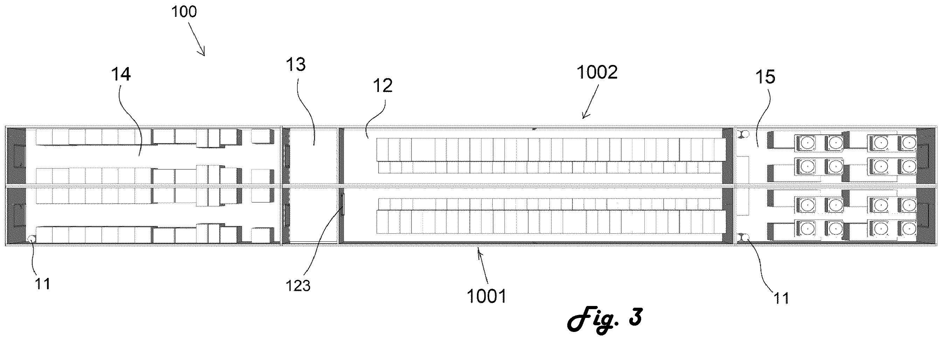

Figures 1 and 3 show a room for IT equipment, i.e., a rack area (12), a room for the dedicated cooling system (15), a fire suppression system (11), an aggregation aisle (13) and a room with a power supply system (14).

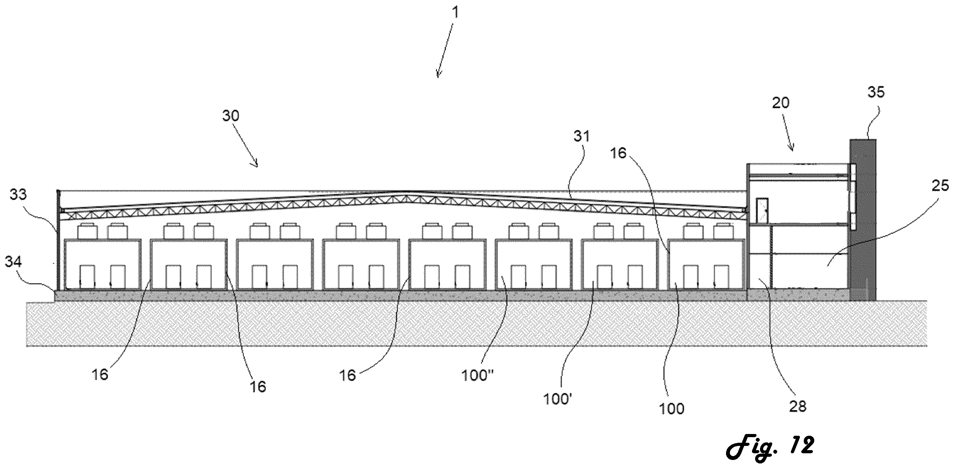

As shown in Figure 12, by twinning and combining the modules (100) a modular data processing center (1) is obtained, functionally equivalent to a conventional data processing center in its essence.

In order to improve logistics, the segments (101, 101', 101", 102, 102', 102") are built with dimensions that do not exceed the load standards of a jurisdiction. Thus, the transportation of the segments (101, 102) can be performed with no need for special requirements to the transportation regulatory agencies of a jurisdiction, except for any special project that may exceed the load standards.

In many jurisdictions, the transportation of non-standard loads (which exceed regulatory dimensions) requires, in addition to special requirements, compliance with strict rules, such as transportation during the early hours of the morning (from 3:00 to 6:00 am, for example), special signage, escorts, among other rules, which make logistics difficult, delay and increase the cost of assembling the modules (100) of a data processing center.

In one embodiment of the invention, the segments (101, 101', 101", 102, 102', 102") are constructed from a container-like structure.

Containers are particularly advantageous for logistics, as they are already adapted for transport by ship, train, and truck. Many jurisdictions accept containers as standard cargo, which facilitates the logistics of the segments (101, 101', 101", 102, 102', 102").

For example, containers (compatible with the dimensions of a segment) have approximate dimensions of 6 m in length, 2.4 m in width, 2.6 m in height and a maximum capacity of 24,000 kg (typical characteristics of a 20-foot container). Another standard container (40 feet) may be approximately 12 meters in length and have other measurements similar to the standard (20 feet).

The composition of the module (100) by means of segments (101, 101', 101", 102, 102', 102") prefabricated within the load standards of a jurisdiction is very advantageous, providing a quick and low-cost assembly of a data processing center (1).

Furthermore, the segments (101, 101', 101", 102, 102', 102") are joined at the data processing center assembly site (1) to form their respective halves (1001, 1002).

Finally, the union of the halves (1001, 1002) forms a module (100) which is the base infrastructure of the data processing center (1) of the present invention, with advantages in relation to cooling efficiency and redundancy.

Module (100) is substantially symmetrical, considering a longitudinal plane substantially perpendicular to the ground.

The segments (101, 101', 101", 102, 102', 102") of their respective halves (1001, 1002) are joined together first. After each of the halves (1001, 1002) are ready, the halves are joined together, forming a module (100).

The modules (100) are then made up of two substantially symmetrical halves (1001, 1002) which are joined together at the assembly site of the data processing center (1).

In some preferred embodiments of the invention, a half (1001, 1002) may be constituted of 2 to 4 pairs of segments (101, 101', 101", 102, 102', 102"). Each of these segments (101, 101', 101", 102, 102', 102") is transported on a trailer and joined at the assembly site of the data processing center (1).

The longitudinally symmetrical module (100) is another advantage of the present invention since it makes it possible to build modular data processing centers (1) with high cooling capacity and redundancy (both thermal and electrical).

The union of two symmetrical halves (1001, 1002) to form the rack area (12) provides a spacious environment, similar to the internal area of a conventional data processing center (1), with separation of hot air (121) and cold air (122) aisles.

The characteristic of having at least two symmetrical halves (1001, 1002) provides a greater mass of air conditioning available inside the rack area (12) of a module (100) of a data processing center (1).

The heat capacity of air depends on its mass. On the other hand, the mass of air under normal temperature and pressure conditions (CNTP) increases proportionally with its volume. Thus, the greater the volume of air, the greater its heat capacity in the rack area (12).

Thus, a larger volume of the rack area (12), provided by the union of the symmetrical halves (1001, 1002), results in a greater cooling capacity and thermal stability of the air in the rack area (12). This means that it is easier to maintain a constant temperature within the rack area (12) of a module (100). In other words, a longer time and/or a greater amount of heat is required for the temperature to vary.

This is particularly advantageous, for example, when there is a momentary failure in the cooling system, the temperature varies little, causing no harm to the operation of the IT equipment present in the racks.

This failure may be caused, for example, by a failure in the electricity supply of the local utility company. In such cases, if there is an interruption in the electricity supply only to the refrigeration equipment, there is enough time to activate a generator without compromising the operation of the IT equipment.

The separation of hot air aisle (121) and cold air aisle (122) and the use of aisle enclosure then lead to the optimization of the use of air for cooling the IT equipment present in the module (100).

Modules for data processing centers are solutions already found in the state of the art, which usually opt for the enclosure of the hot aisle.

The module (100) of the present invention is equipped with a dedicated refrigeration system (15) segregated in its own area, with a view to mitigating risks arising from possible failures, fires, short circuits, among other failures of the refrigeration system (15).

Another advantage of the halves (1001, 1002) being symmetrical is the increase in redundancy and the possibility of sharing technical areas, that is, sharing the refrigeration system (15) and the energy supply system (14), optimizing the use and potentially the redundancy of equipment and systems.

Each of the halves (1001, 1002) is completely autonomous. In principle, only one half (1001) could work alone, that is, with no need for its mirrored other half (1002).

Although this possibility exists, of only one of the halves (1001, 1002) working, it is disadvantageous.

The configuration of one of the halves (1001, 1002) to work alone does not provide an increase in the thermal capacity of the air in the rack area (12), nor does it increase the redundancy of the cooling system (15) and the power supply system (14).

With the symmetrical halves (1001, 1002) connected, redundancy is increased, since in the refrigeration system (15) there is one or more refrigeration equipment in operation and one or more refrigeration equipment on standby (redundancy). If one of the refrigeration equipment in operation fails for any reason, one or more equipment that was on standby (backup) comes into operation.

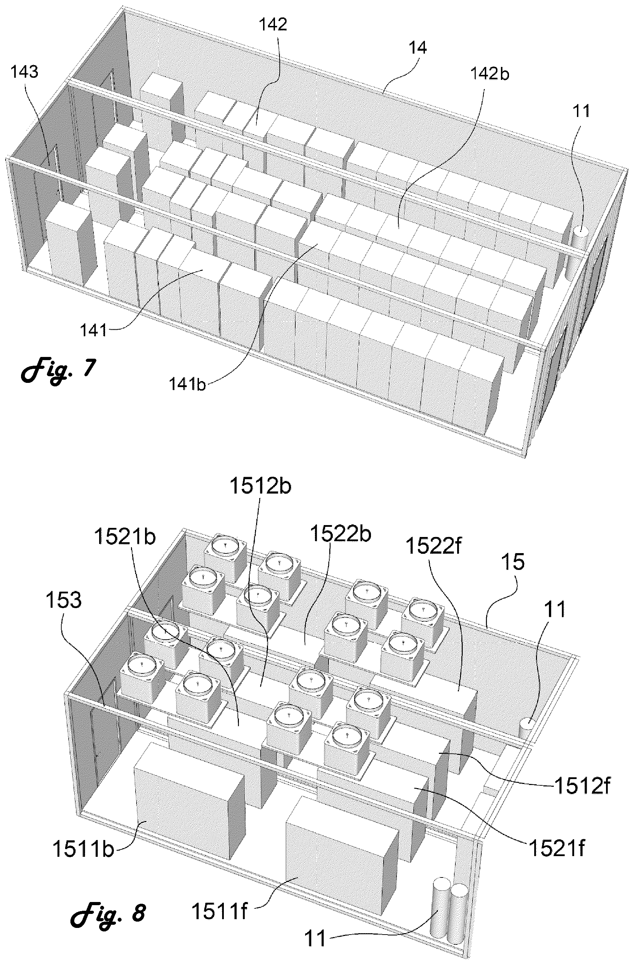

In one embodiment of the present invention, shown in Figure 8, each of the halves (1001, 1002) has its respective cooling system (151, 152).

For example, as shown in Figure 8, the refrigeration system (151) of the first half (1001) comprises two operating equipment (1511f, 1521f) and two standby equipment (1511b, 1521b). The same arrangement is found in its respective symmetrical refrigeration system (152), i.e., in the second half (1002).

If the refrigeration equipment (1511f) fails, the refrigeration equipment (1511b, 1521b) of its half (1001) has the standby (backup) option. Since the halves (151, 152) are integrated, in addition to the refrigeration equipment (1511b, 1521b), there is also the refrigeration equipment (1512b, 1522b) of the other half. This makes the refrigeration system (15) quite robust, redundant, and reliable.

The same redundancy logic applies to the power supply system (14) and the fire suppression systems (11). Therefore, the respective power supply systems (141, 141b, 142, 142b) of each of the halves (1001, 1002) supply the other half in case of failure, with the same logic as the cooling system, that is, even using the respective backup power supply systems (141b, 142b).

Thus, the data processing center (1) of the present invention is made up of one or more modules (100) having an exclusive area for allocating equipment in customer racks, herein referred to as the rack area (12), an aggregation aisle (13) through which controlled circulation of personnel is performed, and a separate technical area.

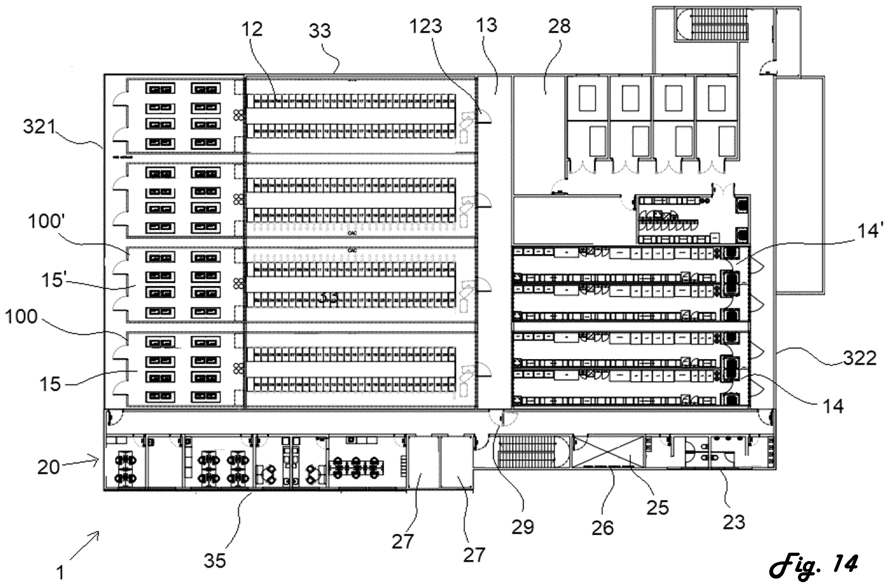

The complete independence of the modules (100) provides scalability to the data processing center, since the modules (100) can be joined side by side in order to increase the capacity of the data processing center, without incurring in immobilization of large volumes of capital at the beginning of the operation of the data processing center (1), as shown exemplarily in Figures 12 and 14.

Furthermore, the internal layout of each of the modules (100) allows for infrastructure redundancy, which translates into robustness, reliability, and uninterrupted operation in the vast majority of postulated failures.

The maintainability of the data processing center (1) is independent of the data processing operation. This advantageous feature is achieved because each module (100) has its own rack area (12) separate from the technical areas.

Access to the power supply system area (14) is preferably conducted by external access and through the main aggregation aisle (13) and access to the cooling system (15) is performed through lateral access (153), which may or may not have an aisle. The cooling system (15) is preferably without the upper covering of the data processing center envelope to aid in the convection of air from the cooling system (15).

Thus, through access (143) to the area of the power supply system (14), it is possible to perform maintenance without even needing to move around the area of the racks (12) of the module (100). Access (143) is preferably a door with access control (for example: biometrics, password, tags, token, etc.).

As shown in Figure 1, the rack area (12) can also be reached for maintenance through exclusive access, which is preferably a door (123) with access control (for example by biometrics, password, tags, token, etc.).

The modules (100) are externally constructed of an armored, water jet proof, fire resistant and substantially metallic structure.

The method of constructing the module (100) consists of joining one end of the segment (101) to its respective adjacent segment (101') and, so on, joining the next adjacent segment (101"), to form the first half (1001).

After all the segments are joined together (101, 101', 101"), the first half (1001) is formed.

By joining one end of the segment (102) to its respective adjacent segment (102') and, so on, joining the next adjacent segment (102"), the second half (1002) is formed.

After all the segments have been joined together (102, 102', 102"), the second half (1002) is formed.

After forming each of the halves (1001, 1002), one half is joined to the other half, thus forming module (100).

In one embodiment of the invention, each module (100) can support up to 60 racks of 600mm width each and 600kVA of electrical power. However, other embodiments are possible, where these specifications may change according to the size of the rack and customization of the required electrical density.

Figure 12 exemplifies an embodiment of a data processing center (1) of the present invention showing its interior. The arrangement of the modules (100, 100', 100") side by side is evident in order to increase (expand) the capacity of the data processing center (1), without discontinuing its operations.

The construction method of a module also comprises one or more modules (100, 100', 100") arranged side by side and interconnected from the larger side faces (16) of the adjacent modules, with the main aggregation aisle (13) aligned between the modules (100, 100', 100").

Expansion can be performed gradually, without the need for a large initial investment, as is the case with conventional data processing centers.

Figure 14 also shows the common aggregation aisle (13). While the aisle (13) integrates, it preserves maintainability, including access via independent doors (123) to each area of the racks (12) of each of the modules (100, 100'). The area of the racks (12) is also known as the data hall.

The aggregation aisle (13) creates usability for customers similar to a conventional data processing center, where they can circulate to access the energy equipment areas (14), rack areas (12) and facilities areas (20).

As shown in Figure 14, access control (29) to the aggregation aisle (13) is preferably performed via the facilities areas (20). For example, access is granted via reception (25) in one embodiment of the invention. Reception (25) grants access by user profile, which may access one or more areas of the racks (12) or only one or more power supply areas (14, 14') or even access both areas. Access controls may also allow access to the refrigeration system (15, 15').

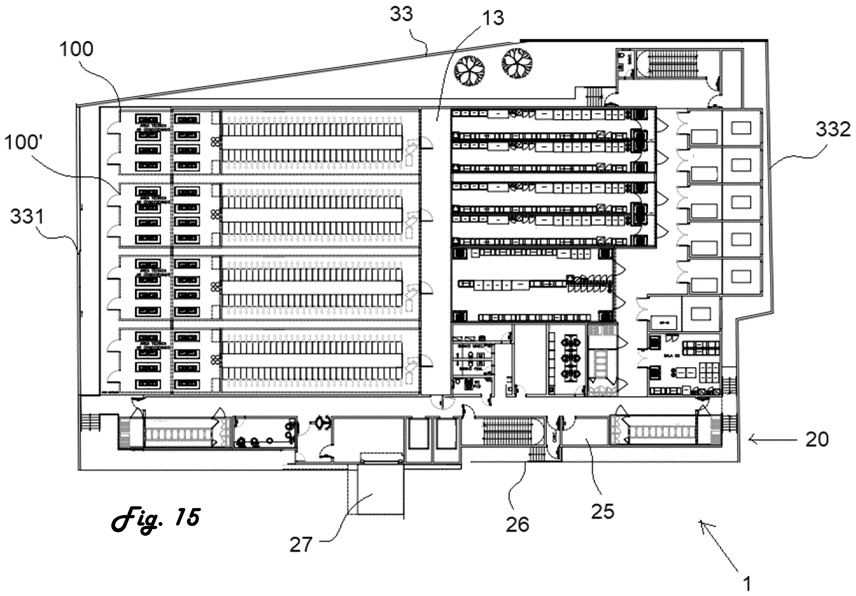

Thus, the circulation of users occurs preferably through the facilities areas (20) which can have different layouts as shown in Figures 15 and 16.

The facilities areas (20) are, for example, the docks (27), reception (25), testing room, stock (28), meeting room, among others.

By aggregating the facility areas (20), a layout is obtained that can be compared to a conventional data processing center. The facility areas (20) are preferably made of masonry.

Figure 14 shows another embodiment of the invention, namely a data processing center (1) with modules (100, 100') positioned side by side, which together form a data processing center (1) with all the advantages of a conventional data processing center.

Figure 12 shows a longitudinal section of an embodiment of the invention. An envelope (30) provides structural and visual integration, which protects the modules (100) against the weather, in addition to providing safe access.

This casing (30) allows for the optional addition of customizable facility, office, and storage areas.

The casing (30) consists of a roof (31), preferably metallic above the modules (100), preferably masonry walls on the sides (321, 322), with the bottom (33) preferably having an access for the introduction of the modules (100). Below, the envelope (30) consists of a floor (34), preferably raised. The facilities area (20) is integrated into the casing (30) so as to constitute the same data processing center assembly (1). The roof (31) preferably does not cover the cooling systems (15) or the generators. The facilities area (20) also has a facade (35).

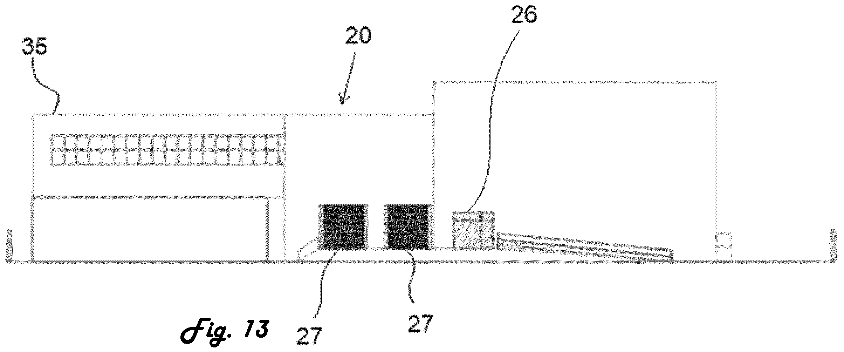

Figure 13 shows a front view, i.e., the main entrance (26) of the data processing center for users (customers and employees). The appearance and functions are similar to a conventional data processing center and with all its technical advantages, but with the flexibility of a modular data processing center.

The present invention contemplates an external structure capable of housing a large quantity of customer IT equipment in racks, with power and cooling capacity to support a wide range of power density per rack, meeting the specifications of the TIA-942 Rated-3 standard of the Telecommunications Industry Association (renowned standardization body in the area of telecommunications and information technology), with a modular structure, but with the user experience of a conventional data processing center.

For the connection between the modules (100) and perfect integration with the other areas of the data processing center (1), an aggregation aisle (13) was created. In addition to there being no infrastructure equipment in the aisle (13), this aisle (13) is integrated with the facilities area (20) such as: reception (25), stock (28), docks (27) among others, becoming a circulation aisle for people, employees, customers, and other users.

Regarding the composition of the module (100), it is armored, water jet-proof, fire-resistant, with capacity for dozens of racks, with access door via biometric identification and/or card reader.

The modules (100) are added to the infrastructure in a practical way, enabling scalability of space and energy capacities by simply adding the modules in parallel.

The data processing center (1) of the present invention allows electrical connectivity of the equipment installed in the racks with redundancy in the supply of electrical energy, uninterrupted monitoring of the entire infrastructure, in addition to monitoring, with the recording of internal and external images by CCTV cameras with night vision and motion sensor.

One of the advantages of the present invention is preventive maintenance, which can be performed through direct access to the infrastructure equipment, avoiding direct contact with the client's IT equipment, which ensures greater stability and operational security.

Another advantage of the invention in question is the use of an external casing (30), which shelters the entire structure, protecting it from direct sunlight, which improves the efficiency of the refrigeration equipment, reducing energy consumption. In addition, the external casing (30) of the modular data processing center (1) of the present invention provides complete access control to the same.

In other words, the external casing (30) protects and structurally integrates the internal parts and other external protection items of the modules, such as walls, providing a general infrastructure similar to a conventional data processing center.

The data processing center (1) of the present invention, in addition to facilitating the planning and execution process of the assembly, together with other units, provides a reduction in the installation time, and it is even possible to obtain a large-scale data processing center (1) without compromising energy efficiency in relation to similar ones existing in the state of the art. In other words, the present invention allows the construction of scalable data processing centers (1), even obtaining the capabilities of large-scale data processing centers (1).

## Claims

1. A data processing center module consisting of prefabricated and transportable segments, the module (100) being substantially parallelepipedal in shape and equipped at one of its ends with a dedicated and segregated room in substantially parallelepipedal shape to house a power supply system (14) and at its opposite end a dedicated and segregated room in substantially parallelepipedal shape to house a refrigeration system (15), **characterized in that** the module (100) is constituted by the union of two halves (1001, 1002) substantially symmetrical in relation to a longitudinal plane perpendicular to a floor (34), each half (1001, 1002) also being constituted by the union of one or more of its respective segments (101, 102), in metal structure, prefabricated and transportable.

2. The data processing center module consisting of prefabricated and transportable segments according to claim 1, **characterized in that** between the room of the power supply system (14) and the room of the cooling system (15), the module (100) is equipped with a main aggregation aisle (13) and a dedicated and segregated room in a substantially parallelepiped shape to house a rack area (12), with a door (123) for access to the racks, equipped with an access control, allowing the circulation of authorized users between the main aggregation aisle (13) and the rack area (12), with a door (143) for access to the power supply equipment (14) also equipped with an access control, allowing the circulation of authorized users between the main aggregation aisle (13) and the power supply system room (14).

3. The data processing center module consisting of prefabricated and transportable segments according to claim 2, **characterized in that** that access to the main aggregation aisle (13) is also controlled and performed by means of a facilities area (20).

4. The data processing center module consisting of prefabricated and transportable segments according to claim 1, **characterized in that** that the union between the first half (1001) and the second half (1002) forms a common hot (121) or cold (122) air containment aisle.

5. The data processing center module consisting of prefabricated and transportable segments according to claim 1, **characterized in that** each of the halves (1001, 1002) is autonomous and shares the refrigeration equipment (1511f, 1521f, 1512f, 1522f) of each other.

6. The data processing center module consisting of prefabricated and transportable segments according to claim 5, **characterized in that** each of the halves (1001, 1002) can share standby refrigeration equipment (1511b, 1521b, 1512b, 1522b) with each other.

7. The data processing center module consisting of prefabricated and transportable segments according to claim 1, **characterized in that** each of the halves (1001, 1002) is autonomous and shares the power supply systems (141, 141b 142, 142b) of each other.

8. A method of constructing a module (100), **characterized in that** said method comprises the following steps:
- segments (101, 102) are manufactured outside the construction site of the module (100);
- each of the segments (101, 102) is transported individually as a standard load to the assembly location of the module (100);
- at the module assembly location (100), the end of one segment (101) is joined to the other end of the adjacent segment (101'), forming the first half (1001);
- at the assembly location of the module (100), the end of one segment (102) is joined to the other end of the adjacent segment (102'), forming the second half (1002), with the halves (1001, 1002) being substantially symmetrical;
- after the formation of each of the halves (1001, 1002), a first half (1001) is joined to the second half (1002), forming the module (100).

9. A data processing center constituted from the module, of claim 1, **characterized in that** it comprises one or more modules (100, 100', 100") arranged side by side and interconnected from the larger side faces (16) of the adjacent modules (100), with the main aggregation aisle (13) aligned between the modules (100).

10. The data processing center according to claim 9, **characterized in that** the first module (100) of the data processing center (1) is arranged next to the facilities area (20), with user access control to one or more modules (100) being performed through said facilities area (20).

11. The data processing center according to claim 9, **characterized in that** it is provided with an casing (30) limited at the bottom by a floor (34) where the data processing center (1) is mounted; limited at the top by a roof (31), which houses the data processing center (1) in whole or in part; limited laterally and at the bottom respectively by closures (321, 322, 33), wherein at least one of said closures (321, 322, 33) is performed by means of gates compatible, at least, with the dimensions of the segments (101, 101', 101", 102, 102', 102"); limited at the front by the facilities area (20) which is integrated into the envelope (30) so as to constitute the same data processing center set (1).

12. A method of construction of the data processing center (1) of claim 9, **characterized in that** it comprises the steps in any order:
a) construction of the casing (30), constructed from the execution of the sub-steps executed in any order:
- construction of a solid base or raised floor (34) on which the data processing center (1) will be built;
- construction of the facilities area (20);
- construction of the roof structure (31);
- placement of the roof (31);
- side closures (321, 322);
- bottom closure (33);
b) insertion of the segments (101, 101', 101", 102, 102', 102") inside the envelope (30), which are assembled from the sub-steps executed in any order:
- the segments (101, 101', 101") are joined to form a first half (1001);
- segments (102, 102', 102") substantially symmetrical to segments (101, 101', 101") are joined to form a second half (1002) substantially symmetrical to the first half (1001);
- after the formation of each of the halves (1001, 1002), a first half (1001) is joined to the second half (1002), forming the module (100);
c) the modules (100) are arranged side by side inside the casing (30) to form the modular data processing center (1).
